# EUROPEAN PATENT APPLICATION

(11) **EP 4 481 796 A1**
(43) Date of publication of application: **25.12.2024**
(21) Application number: 23756127.9
(22) Date of filing: 26.01.2023
(51) Int. Cl.: H01L 21/314, C01B 32/25, C23C 16/27, C30B 25/18, C30B 29/04, H01L 21/31

(54) **METHOD FOR GROWING DIAMOND ON SILICON SUBSTRATE AND METHOD FOR SELECTIVELY GROWING DIAMOND ON SILICON SUBSTRATE**

(30) Priority: 15.02.2022 JP 2022020997
(71) Applicant: Shin-Etsu Handotai Co., Ltd., Tokyo 100-0004 (JP)
(72) Inventor: MATSUBARA, Toshiki, Nishishirakawa-gun, Fukushima 961-8061 (JP); SUZUKI, Katsuyoshi, Annaka-shi, Gunma 379-0196 (JP); TANAKA, Yuki, Nishishirakawa-gun, Fukushima 961-8061 (JP); SUZUKI, Atsushi, Nishishirakawa-gun, Fukushima 961-8061 (JP); SUZUKI, Kenta, Nishishirakawa-gun, Fukushima 961-8061 (JP); TAGA, Ryo, Nishishirakawa-gun, Fukushima 961-8061 (JP); ABE, Tatsuo, Nishishirakawa-gun, Fukushima 961-8061 (JP); OHTSUKI, Tsuyoshi, Nishishirakawa-gun, Fukushima 961-8061 (JP)
(74) Representative: Mooser, Sebastian Thomas
(86) International application number: PCT/JP2023/002500
(87) International publication number: WO 2023/157599

(57) **Abstract**

The present invention is a method for growing diamond on a silicon substrate, the method includes: subjecting a surface of the silicon substrate to damage as a pretreatment so as to make a Raman shift of a peak at 520 cm⁻¹ in Raman spectroscopy 0.1 cm⁻¹ or more, or subjecting the surface of the silicon substrate to unevenness formation as the pretreatment so as to make a surface roughness Sa measured by AFM 10 nm or more, or subjecting the surface of the silicon substrate to both the damage and the unevenness formation thereon as the pretreatment, and growing diamond by a CVD method on the silicon substrate subjected to the pretreatment. This provides a method for growing diamond on a silicon substrate and a method for selectively growing diamond on a silicon substrate.

## Description

### TECHNICAL FIELD

The present invention relates to a method for growing diamond on a silicon substrate and a method for selectively growing diamond on a silicon substrate.

### BACKGROUND ART

Diamond is expected to be applied to various semiconductor devices and electronic devices due to excellent physical property values such as high hardness, good thermal conductivity, high carrier mobility, and wide bandgap. As for these semiconductor devices and the electric devices applications, artificially synthesized diamond is used. The synthesis of diamond has two methods: a growth using ultra high pressure and vapor deposition; in view of applications for semiconductors, vapor deposition (CVD growth) is attracting attention for being capable of obtaining large diameters (Patent Documents 1 to 3).

The CVD growth is a method for placing a substrate in a reaction tube while flowing a raw material gas and a carrier gas under normal pressure or reduced pressure, thereby decomposing and activating the raw material gas by pyrolysis or plasma to grow a film on the substrate.

In the growth of diamond, a micro-wave plasma, a DC plasma, and a hot filament method, in which a filament such as tungsten is used, are adopted; however, when considering the application to large diameter substrates, the hot filament method, which theoretically allows for a larger diameter, is attracting attention.

The hot filament method is also an excellent technique used for diamond coating of tools and jigs; however, nucleation for a nucleus of the growth has been considered necessary to grow the diamond on the substrates (Patent Document 4). In particular, when silicon substrates are used as the diamond growth substrates, this nucleation is important.

The nucleus of the growth is regarded to require treatments such as immersing the substrate into a solution containing diamond particles to dry afterward, immersing the substrate into a solution containing diamond particles to apply ultrasonic waves, or introducing gases such as methane to perform DC plasma treatment.

### CITATION LIST

### PATENT LITERATURE

Patent Document 1: JP 2001-354491 A
Patent Document 2: JP 2004-176132 A
Patent Document 3: JP 2006-143561 A
Patent Document 4: JP 2013-166692 A

### NON PATENT LITERATURE

Non Patent Document 1: Wei Li et. al., "Modeling of the removal mechanism of monocrystalline silicon - based on phase change - dislocation theory and its edge chipping damage during micro - griping", Precision Eng., 71 (2021) 103-118.

### SUMMARY OF INVENTION

### TECHNICAL PROBLEM

In this way, a large-diameter diamond substrate has attracted attention in light of a heat-dissipating property thereof, etc. Although a hot-filament CVD method is present as a growth method corresponding to a large diameter, seeding for making a nucleus of a growth is required, and other than homoepitaxy, pretreatments such as ultrasonic treatments with coating diamond particles or DC plasma are required. In particular, although the ultrasonic treatment with coating the diamond particles can correspond to the large diameter substrate, application thereof to a semiconductor process is impossible due to problems including contamination or the particles. On the other hand, the DC plasma treatment has not been able to achieve a larger diameter, such as a diameter of 300 mm, for example.

In addition, a selective growth of diamond to a predetermined area becomes necessary. This is because the diamond is difficult to process due to high hardness thereof, and also difficult to process after forming a film on the entire surface due to a problem of progressing oxidation at high temperatures in the presence of oxygen.

The present invention has been made to solve the above-described problem. An object of the present invention is to provide a method for growing diamond on a silicon substrate and a method for selectively growing diamond on a silicon substrate with a simple and easy manufacturing process while suppressing contamination and particles.

### SOLUTION TO PROBLEM

To achieve the object, the present invention provides a method for growing diamond on a silicon substrate, the method comprising:
subjecting a surface of a silicon substrate to damage as a pretreatment so as to make a Raman shift of a peak at 520 cm⁻¹ in Raman spectroscopy 0.1 cm⁻¹ or more;
or subjecting the surface of the silicon substrate to unevenness formation as the pretreatment so as to make a surface roughness Sa measured by AFM 10 nm or more;
or subjecting the surface of the silicon substrate to both the damage and the unevenness formation thereon as the pretreatment; and
growing diamond by a CVD method on the silicon substrate subjected to the pretreatment.

With such a method for growing diamond on a silicon substrate, the diamond having a large diameter can be obtained with a simple and easy manufacturing process while suppressing contamination and particles.

In this event, it is preferred that the CVD method is a hot filament method.

By using such a CVD method, the diamond having the large diameter can be obtained more efficiently.

In addition, the present invention provides a method for selectively growing diamond on a silicon substrate, the method comprising:
in the method for growing diamond on a silicon substrate described above,
subjecting only a part of a region on the surface of the silicon substrate to the damage as a pretreatment,
or subjecting only a part of a region on the surface of the silicon substrate to the unevenness formation as the pretreatment,
or subjecting only a part of the surface of the silicon substrate to both the damage and the unevenness formation as the pretreatment; and
growing diamond by a CVD method on the region where the pretreatment is performed.

With such a method for selectively growing diamond on a silicon substrate, the selectively diamond-grown substrate having a large diameter can be obtained with a simple and easy manufacturing process while suppressing contamination and particles.

At this time, it is preferred that the CVD method is a hot filament method.

By using such a CVD method, the selectively diamond-grown substrate having the large diameter can be obtained more efficiently.

### ADVANTAGEOUS EFFECTS OF INVENTION

According to a structure of the invention, it is possible to grow a diamond nucleus of the growth by controlling parameters of the surface of the silicon substrate with specific value, and it is also possible to grow the diamond on the silicon substrate by a simple and easy production process without generating contamination or particles.

### BRIEF DESCRIPTION OF DRAWINGS

FIG. 1 is a view illustrating an example of a schematic view of a method for growing diamond using a hot filament method according to the present invention.
FIG. 2 is a graph illustrating a Raman peak of diamond on a silicon substrate.
FIG. 3 is a view illustrating a relation between a Raman shift amount of a peak at 520 cm⁻¹ of a silicon substrate and a diamond growth.
FIG. 4 is a view illustrating a relation between an AFM roughness of a silicon substrate and a diamond growth.
FIG. 5 is a flowchart illustrating an example of a selective diamond growth flow on a silicon substrate.
FIG. 6 is a figure illustrating Raman spectra and optical microscope images after a CVD growth on a partially polished silicon substrate.
FIG. 7 is a figure illustrating Raman spectra and optical microscope images after a CVD growth on a partially dry-etched silicon substrate.
FIG. 8 is a figure illustrating another example of Raman spectra and optical microscope images after a CVD growth on a partially dry-etched silicon substrate.

### DESCRIPTION OF EMBODIMENTS

As described above, it is desired to develop a method for growing a diamond on a silicon substrate that can suppress contamination and particles.

To solve the above problem, the present inventors have earnestly studied and found that diamond can be grown on a silicon substrate while suppressing contamination and particles by subjecting a surface of the silicon substrate to damage, or forming unevenness, or both above treatments. This led to the completion of the present invention.

That is, the present invention is a method for growing diamond on a silicon substrate, the method includes subjecting a surface of the silicon substrate to damage as a pretreatment so as to make a Raman shift of a peak at 520 cm⁻¹ in Raman spectroscopy 0.1 cm⁻¹ or more, or subjecting the surface of the silicon substrate to unevenness formation as the pretreatment so as to make a surface roughness Sa measured by AFM 10 nm or more, or subjecting the surface of the silicon substrate to both the damage and the unevenness formation thereon as the pretreatment, and growing diamond by a CVD method on the silicon substrate subjected to the pretreatment.

In this case, the pretreatment may be performed on an entire surface of the silicon substrate or a part of a region.

Hereinafter, the present invention will be described in detail. However, the present invention is not limited thereto. The embodiments of the present invention will be described with reference to the drawings.

### [Method for Growing Diamond on Silicon Substrate]

The inventive method for growing diamond on a silicon substrate includes a method for growing diamond on a silicon substrate, the method includes: subjecting a surface of the silicon substrate to damage as a pretreatment so as to make a Raman shift of a peak at 520 cm⁻¹ in Raman spectroscopy 0.1 cm⁻¹ or more, or subjecting the surface of the silicon substrate to unevenness formation as the pretreatment so as to make a surface roughness Sa measured by AFM 10 nm or more, or subjecting the surface of the silicon substrate to both the damage and the unevenness formation thereon as the pretreatment, and growing diamond by a CVD method on the silicon substrate subjected to the pretreatment.

In this event, it is preferred that the CVD method is a hot filament method.

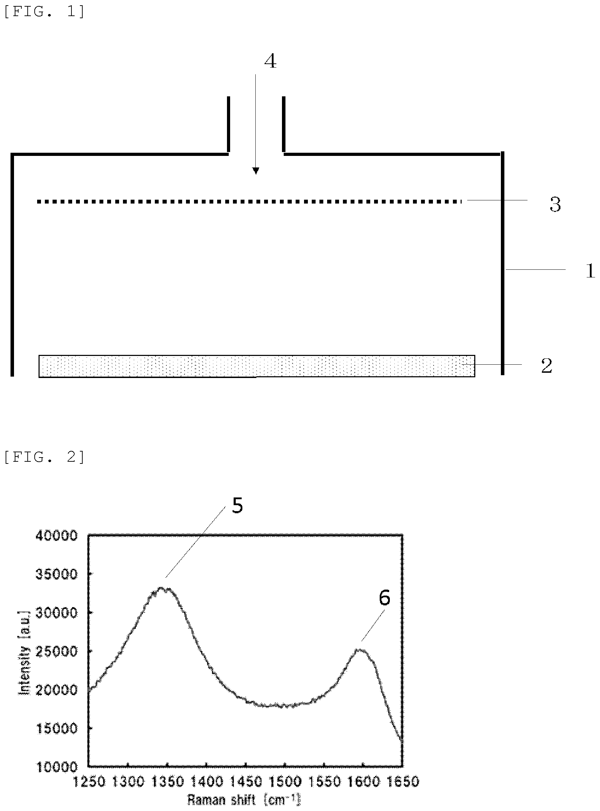

FIG. 1 shows an example of an embodiment and schematically shows a method for growing diamond using a hot filament method. Methane and hydrogen are introduced into a reaction vessel 1 as a reaction gas 4, and a tungsten filament 3 installed above the silicon substrate (to be film-formed substrate) 2 is energized to electric-heat and then decompose the reaction gas 4, thereby growing diamond on the silicon substrate 2. A nucleation on the silicon substrate at this time is described. When a normal silicon substrate is measured by Raman spectroscopy, a peak at 520 cm⁻¹ is obtained. When this silicon substrate is subjected to damage, this peak shifts. As for the change of Raman peak when scratched, for example, Non Patent Document 1 discloses a comparison between a depth (degree) of a scratch and Raman, showing that the peak at 520 cm⁻¹ shifts as the degree of the scratch becomes larger (more severe).

As for a method for subjecting the silicon substrate surface to the damage, for example, a method for grinding the silicon substrate surface with a grindstone can be mentioned. In addition, for a method for subjecting the silicon substrate surface to the roughness, for example, a method for grinding the silicon substrate surface with a grindstone can be mentioned. A method includes immersing the substrate in pure water with diamond particles dispersed therein and applying ultrasonic waves to damage or roughen the surface. Moreover, other than such methods for mechanical damaging or roughening, for example, a method for using DC plasma (applying high voltage to the substrate and ionizing gases such as Ar or methane with plasma) to subject damage by ion particles is also available.

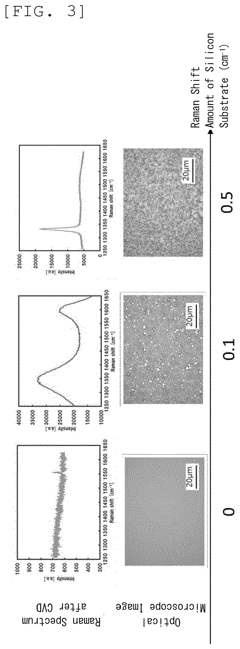

In this way, the damage on the surface can be evaluated by the Raman shift; samples are produced by changing the amount of the Raman shift, and then a diamond growth is performed by the hot filament method, resulting in the diamond growth is confirmed at a place where the amount of the Raman shift of 0.1 cm⁻¹ or more, preferably 0.5 cm⁻¹ or more as shown in FIG. 3, that is, at a place where the damage becomes larger. The upper limit of the Raman shift is not particularly limited but can be, for example, defined as 2 cm⁻¹ or less.

At this point, the growth of the diamond is confirmed by performing a Raman measurement and a resulting peak thereof at 1330 cm⁻¹ and an optical microscope image. For example, as shown in FIG. 2, when Raman peak 5 of the diamond is confirmed in the vicinity of 1330 cm⁻¹, the growth of the diamond is indicated. Note that, in the vicinity of 1600cm⁻¹, Raman peak 6 of carbide (graphite) can be confirmed.

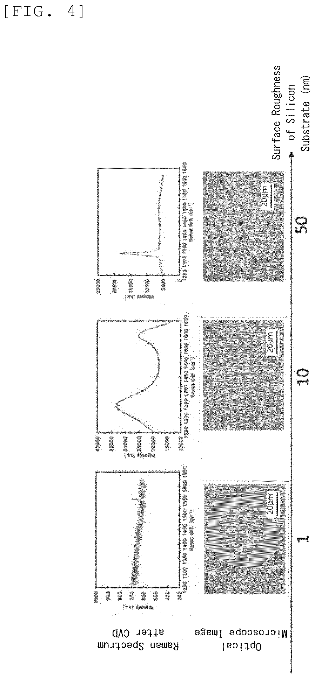

In a schematic view of the method for growing diamond using the hot filament method (FIG. 1), methane and hydrogen are introduced into the reaction vessel 1 as the reaction gas 4, and the tungsten filament 3 installed above the silicon substrate 2 is energized to electric-heat and then decompose the reaction gas 4, thereby growing diamond on the silicon substrate 2. As the nucleation to the silicon substrate 2 at this time, samples are produced by changing surface roughness Sa measured by AFM of the silicon substrate 2. Then, the diamond growth is performed by the hot filament method, and then the growth of the diamond can be confirmed when the surface roughness Sa is 10 nm or more and 50 nm or more, as shown in FIG. 4. At this point, the growth of the diamond is confirmed by performing a Raman measurement and a resulting peak thereof at 1330 cm⁻¹ and the optical microscope image. The upper limit of the surface roughness Sa is not particularly limited but can be, for example, 5000 nm or less.

The AFM measurement can be performed, for example, by XE-WAFER manufactured by Park Systems Corp.

In a schematic view of the method for growing diamond using the hot filament method (FIG. 1), methane and hydrogen are introduced into the reaction vessel 1 as the reaction gas 4, and the tungsten filament 3 installed above the silicon substrate 2 is energized to electric-heat and then decompose the reaction gas 4, thereby growing diamond on the silicon substrate 2. As the nucleation (pretreatment) to the silicon substrate 2 at this time, samples are produced by changing the amount of Raman shift and the surface roughness Sa measured by AFM of the silicon substrate 2. Subsequently, with performing the diamond growth by the hot filament method, the growth of the diamond can be confirmed at an area where the Raman shift amount is 0.1 cm⁻¹ or more, preferably 0.5 cm⁻¹ or more when the Raman measurement of a peak at 520 cm⁻¹ is measured on the surface of the silicon substrate 2, that is, at the area where the damage is larger, and the surface roughness Sa of the silicon substrate 2 measured by AFM is 10 nm or more and 50 nm or more. In this case, the growth of the diamond is confirmed by performing the Raman measurement and a resulting peak at 1330 cm⁻¹ and the optical microscope image.

### [Method for Selectively Growing Diamond on Silicon Substrate]

Meanwhile, the present invention is a method for selectively growing diamond on a silicon substrate, the method includes, in the method for growing diamond on a silicon substrate described above, subjecting only a part of a region on the surface of the silicon substrate to the damage as a pretreatment, or subjecting only a part of a region on the surface of the silicon substrate to the unevenness formation as the pretreatment, or subjecting only a part of the surface of the silicon substrate to both the damage and the unevenness formation as the pretreatment, and growing diamond by a CVD method on the region where the pretreatment is performed.

In this case, it is preferred that the CVD method is a hot filament method.

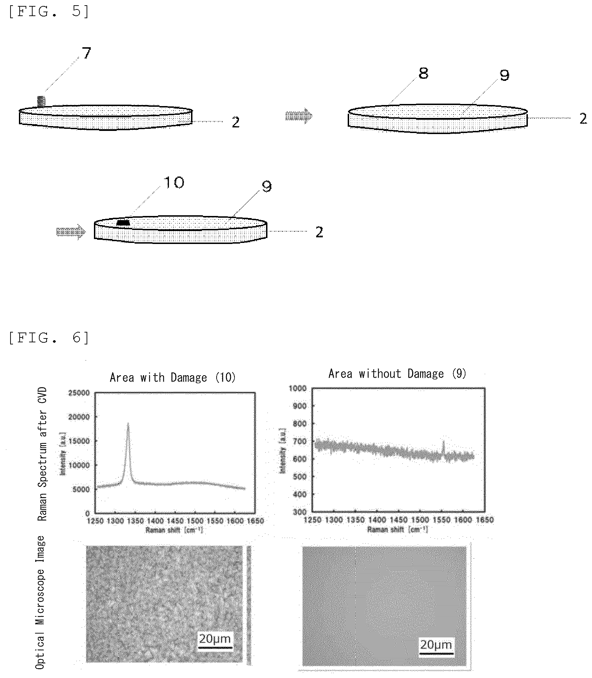

As described above, damage on a surface can be evaluated by Raman shift. Samples of silicon substrates on which an amount of Raman shift is partially changed are produced (FIG. 5), and then a diamond growth method is performed by a hot filament method, as a result, where the Raman shift amount is 0.1 cm⁻¹ or more, i.e., at an area where damage is larger, a partially selective growth of diamond can be confirmed. In FIG. 5, to begin with, a pad portion 7 of a partial polishing apparatus is applied on the silicon substrate 2 to produce a polished-to-roughen area 8 and an unpolished area 9. Then, a CVD-grown diamond 10 is produced on the polished-to-roughen area 8.

At this point, the growth of the diamond is confirmed by performing a Raman measurement and a resulting peak thereof at 1330 cm⁻¹ and an optical microscope image.

As for a method for partially subjecting the surface to the damage, for example, it is possible to polish (grind) only a predetermined area by a partially polishing (grinding) apparatus, or as another method, it is possible to perform photolithography and then perform a method for performing wet or dry etching, etc.

In a schematic view of the method for growing diamond using the hot filament method (FIG. 1), methane and hydrogen are introduced into a reaction vessel 1 as a reaction gas 4, and a tungsten filament 3 installed above a silicon substrate 2 is energized to electric-heat and then decompose the reaction gas 4, thereby growing diamond on the silicon substrate 2. As the nucleation (pretreatment) to the silicon substrate 2 at this time, samples are produced by partially changing surface roughness Sa measured by AFM of the silicon substrate 2. Then, the diamond growth is performed by the hot filament method, and then the partially selective growth of the diamond can be confirmed (FIG. 5) when the surface roughness Sa is 10 nm or more. At this point, the growth of the diamond is confirmed by performing a Raman measurement and a resulting peak thereof at 1330 cm⁻¹ and an optical microscope image.

As for a method for partially subjecting the surface to the roughness, for example, it is possible to polish (grind) only a predetermined area by the partially polishing (grinding) apparatus, or as another method, a method for performing photolithography and then performing wet or dry etching, etc. can be selected.

In a schematic view of the method for growing diamond using the hot filament method (FIG. 1), the methane and the hydrogen are introduced into the reaction vessel 1 as the reaction gas 4, and the tungsten filament 3 installed above the silicon substrate 2 is energized to electric-heat and then decompose the reaction gas 4, thereby growing diamond on the silicon substrate 2. As the nucleation to the silicon substrate 2 at this time, samples are produced by changing the amount of Raman shift and the surface roughness Sa measured by AFM of the silicon substrate 2. Subsequently, with performing the diamond growth by the hot filament method, the partially selective growth of the diamond can be confirmed at an area where the Raman shift amount is 0.1 cm⁻¹ or more, preferably 0.5 cm⁻¹ or more when the Raman measurement of a peak at 520 cm⁻¹ is measured on the surface; that is, at the area where the damage is larger, and the surface roughness Sa of the silicon substrate 2 measured by AFM is 10 nm or more and 50 nm or more (FIG. 5). In this case, the growth of the diamond is confirmed by performing a Raman measurement and a resulting peak thereof at 1330 cm⁻¹ and an optical microscope image.

As for a method for partially subjecting the surface to the damage and roughness, for example, it is possible to polish (grind) only a predetermined area by the partially polishing (grinding) apparatus, or as another method, a method for performing photolithography and then performing wet or dry etching, etc. can be selected.

### EXAMPLE

Hereinafter, the present invention will be specifically described with reference to Examples and Comparative Examples. However, the present invention is not limited thereto.

### (Example 1)

A boron-doped high resistance single crystal silicon substrate having a diameter of 300 mm and orientation (111) was provided, and then three types of substrates having different surface conditions were provided in which an intact substrate (CMP processed), ground by a grindstone of 12000 grit, and ground by a grindstone of 3000 grit. Raman measurements were performed to respective substrate surfaces to evaluate a peak shift of silicon from 520 cm⁻¹; that of the CMP processed substrate had a shift amount of 0 cm⁻¹, that of 12000 grit ground had 0.1 cm⁻¹, that of 3000 grit ground had 0.5 cm⁻¹.

Each of these substrates was placed in a hot filament CVD apparatus and grown for 4 hours under the following conditions: a filament temperature: 2200°C, an H₂ flow rate: 10 SLM, a CH₄ concentration: 3 %, a substrate temperature: 850°C, 5 Torr (667 Pa). The Raman measurements were then performed to evaluate diamond growth. As a result, a relationship between a Raman shift amount of the silicon substrate and the diamond growth was observed, with no diamond growth observed when the Raman shift amount of the silicon substrate was 0 cm⁻¹, but the diamond growth was observed when the Raman shift was 0.1 cm⁻¹ or more (FIG. 3) .

### (Example 2)

A boron-doped high resistance single crystal silicon substrate having a diameter of 300 mm and orientation (111) was provided, and then three types of substrates having different surface conditions were provided in which an intact substrate (CMP processed), ground by a grindstone of 12000 grit, and ground by a grindstone of 3000 grit. When roughness measurement on each substrate surface by AFM was performed, a roughness Sa of the CMP processed substrate was 1 nm, that of 12000 grit ground was 10 nm, and that of 3000 grit ground was 50 nm. However, due to the unreliability of AFM for Sa = 50 nm (3000 grit), the results were also confirmed with a visual field of 100 um using a white-light interference microscope.

Each of these substrates was placed in a hot filament CVD apparatus and grown for 4 hours under the following conditions: a filament temperature: 2200°C, an H₂ flow rate: 10 SLM, a CH₄ concentration: 3 %, a substrate temperature: 850°C, 5 Torr (667 Pa). Raman measurements were then performed to evaluate a diamond growth. As a result, a relationship between the surface roughness Sa of the silicon substrate and the diamond growth was observed, with no diamond growth observed when the surface roughness Sa of the silicon substrate was 1 nm, but the diamond growth was observed when the surface roughness Sa was 10 nm or more (FIG. 4).

### (Example 3)

A boron-doped high resistance single crystal silicon substrate having a diameter of 300 mm and orientation (111) was provided, and then a surface thereof was ground by a small grindstone of 12000 grit using a partially polishing apparatus to perform Raman measurement of the substrate surface; then, a sample in which a peak shift amount of silicon from 520 cm⁻¹ was 0.1 cm⁻¹ was provided.

This substrate was placed in a hot filament CVD apparatus and grown for 4 hours under the following conditions: a filament temperature: 2200°C, an H₂ flow rate: 10 SLM, a CH₄ concentration: 3 %, a substrate temperature: 850°C, 5 Torr (667 Pa). The Raman measurement was then performed to evaluate a diamond growth. As a result, the diamond growth was observed only in the partially ground area on the silicon substrate (FIG. 6).

### (Example 4)

A boron-doped high resistance single crystal silicon substrate having a diameter of 300 mm and orientation (111) was provided, and then a surface thereof was ground by a small grindstone of 12000 grit using a partially polishing apparatus to perform a roughness measurement by AFM of the substrate surface, then the surface roughness Sa was 10 nm.

This substrate was placed in a hot filament CVD apparatus and grown for 4 hours under the following conditions: a filament temperature: 2200°C, an H₂ flow rate: 10 SLM, a CH₄ concentration: 3 %, a substrate temperature: 850°C, 5 Torr (667 Pa). The Raman measurement was then performed to evaluate a diamond growth. As a result, the diamond growth was observed only in the partially ground area on the silicon substrate (FIG. 6).

### (Example 5)

A boron-doped high resistance single crystal silicon substrate having a diameter of 300 mm and orientation (111) was provided, photolithography was then performed thereon to form a window only in a predetermined area, and then the substrate was etched in a plasma etching apparatus for 5 minutes under conditions of a flow rate of 100 sscm and 100 Torr (13332 Pa) using CF₄ as an etching gas. Then, a resist was removed by oxygen plasma to measure roughness and damage by Raman and AFM. As a result, the roughness Sa by AFM was 15 nm, and a peak shift amount at 520 cm⁻¹ in the Raman spectrum was 1 cm⁻¹.

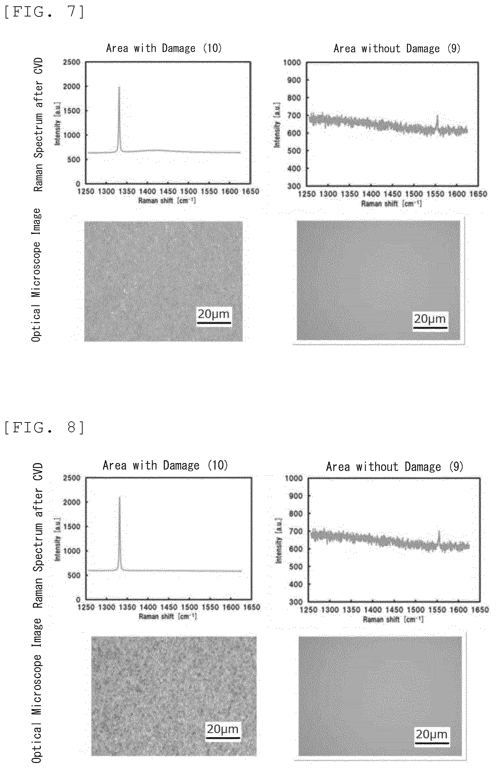

This substrate was placed in a hot filament CVD apparatus and grown for 4 hours under the following conditions: a filament temperature: 2200°C, an H₂ flow rate: 10 SLM, a CH₄ concentration: 3 %, a substrate temperature: 850°C, 5 Torr (667 Pa). The Raman measurement was then performed to evaluate a diamond growth. As a result, the diamond growth was observed only in the partially ground area on the silicon substrate (FIG. 7).

### (Example 6)

A boron-doped high resistance single crystal silicon substrate having a diameter of 300 mm and orientation (111) was provided, and the substrate was oxidized to form a silicon oxide film of 100 nm, and then photolithography was performed to form a window to the oxide film only in a predetermined area. Subsequently, etching was performed with 10 % KOH aqueous solution for 5 min. The oxide film was then removed with buffered HF, and roughness and damage were measured by Raman and AFM. As a result, the roughness Sa by AFM was 50 nm, and a peak shift amount at 520 cm⁻¹ in the Raman spectrum was 1.2 cm⁻¹.

This substrate was placed in a hot filament CVD apparatus and grown for 4 hours under the following conditions: a filament temperature: 2200°C, an H₂ flow rate: 10 SLM, a CH₄ concentration: 3 %, a substrate temperature: 850°C, 5 Torr (667 Pa). The Raman measurement was then performed to evaluate a diamond growth. As a result, the diamond growth was observed only in the partially ground area on the silicon substrate (FIG. 8).

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for growing diamond on a silicon substrate, the method comprising:
subjecting a surface of a silicon substrate to damage as a pretreatment so as to make a Raman shift of a peak at 520 cm⁻¹ in Raman spectroscopy 0.1 cm⁻¹ or more;
or subjecting the surface of the silicon substrate to unevenness formation as the pretreatment so as to make a surface roughness Sa measured by AFM 10 nm or more;
or subjecting the surface of the silicon substrate to both the damage and the unevenness formation thereon as the pretreatment; and
growing diamond by a CVD method on the silicon substrate subjected to the pretreatment.

2. The method for growing diamond on a silicon substrate according to claim 1, wherein
the CVD method is a hot filament method.

3. A method for selectively growing diamond on a silicon substrate, the method comprising:
in the method for growing diamond on a silicon substrate according to claim 1,
subjecting only a part of a region on the surface of the silicon substrate to the damage as a pretreatment,
or subjecting only a part of a region on the surface of the silicon substrate to the unevenness formation as the pretreatment,
or subjecting only a part of the surface of the silicon substrate to both the damage and the unevenness formation as the pretreatment; and
growing diamond by a CVD method on the region where the pretreatment is performed.

4. The method for selectively growing diamond on a silicon substrate according to claim 3, wherein
the CVD method is a hot filament method.
